**Europäisches Patentamt**

**European Patent Office**

**Office européen des brevets**

(19)

(11) Veröffentlichungsnummer: **0 044 093**
**B1**

(12) **EUROPÄISCHE PATENTSCHRIFT**

(45) Veröffentlichungstag der Patentschrift: **09.11.88**

(21) Anmeldenummer: **81200498.4**

(22) Anmeldetag: **11.05.81**

(51) Int. Cl.⁴: **G 01 N 3/52**, G 01 N 3/30, G 01 R 31/34, H 02 K 3/487

(54) **Verfahren zum Prüfen der Güte der Verkeilung der nutenteiligen Wicklung des Stators einer dynamoelektrischen Maschine.**

(30) Priorität: **15.07.80 CH 5401/80**

(43) Veröffentlichungstag der Anmeldung:
**20.01.82 Patentblatt 82/03**

(45) Bekanntmachung des Hinweises auf die Patenterteilung:
**09.11.88 Patentblatt 88/45**

(84) Benannte Vertragsstaaten:
**AT CH DE FR GB IT LI NL SE**

(56) Entgegenhaltungen:
**MICROTECHNIC, Nr. 2, 1979, Seiten 11-17, Zürich, CH. D. LEEB: "Neues dynamisches Messverfahren zur Härteprüfung metallischer Werkstoffe"**
**Brockhaus der Naturwissenschaffen und der Technik, Wiesbaden, 1971, S. 322, 323**

(73) Patentinhaber: **BBC Brown Boveri AG**
**Haselstrasse**
**CH-5401 Baden (CH)**

(72) Erfinder: **Hutter, Wilfried**
**Lachernweg 6**
**CH-8952 Schlieren (CH)**
Erfinder: **Schuler, Roland**
**Aehrenweg 7**
**CH-5430 Wettingen (CH)**

(74) Vertreter: **Ritscher, Thomas**
**RITSCHER & SEIFERT Patentanwälte VSP**
**Kreuzstrasse 82**
**CH-8032 Zurich (CH)**

Courier Press, Leamington Spa, England.

**Beschreibung**

Die vorliegende Erfindung betrifft ein Verfahren zum Prüfen der Güte der Verkeilung der nutenteiligen Wicklung des Stators einer dynamoelektrischen Maschine durch Anschlagen jedes Keils und Erfassung und Bewertung der hierdurch hervorgerufenen Reaktion zur Prüfung der mechanischen Verspannung aller Keile in den Nuten.

Bei grossen dynamoelektrischen Maschinen und insbesondere Turbogeneratoren enthält die Statorwicklung stabförmige, elektrische Leiter, die in die Statornuten eingelegt sind. Die Leiter sind gegeneinander und gegen den Stator elektrisch isoliert und ihre in axialer Richtung aus dem Stator vorstehenden Enden sind in vorgegebener Weise miteinander verbunden.

Die stabförmigen Leiter und Zwischenlagen müssen auf der gesamten Länge der Nut gehalten werden. Die Halterung soll mindestens während der Dauer einer normalen Betriebsperiode, die bei grossen Generatoren bis zu zehn Jahre betragen kann, eine thermische Dilatation ermöglichen, beispielsweise beim Anfahren der Maschine, und zugleich jede freie Bewegung zwischen den Teilen in der Nut und gegenüber der Nutenwand verhindern. Solche Bewegungen, beispielsweise beim Betrieb der Maschine erzeugte Vibrationen, könnten insbesondere die Isolation der stabförmigen Leiter beschädigen, was mindestens kostspielige Reparaturen erfordert, aber auch zur Zerstörung von Teilen der Maschine und damit zu deren Ausfall führen kann.

Eine bewährte Halterung für die in eine Nut eingelegten Teile besteht aus einer Mehrzahl relativ kurzer Keile, die in zwei im äusseren Bereich der beiden Nutenwände in der Längsrichtung der Nut verlaufende Vertiefungen eingeschoben sind. Damit diese Halterung die geforderte Wirkung hat, wird jeder Keil mit Zwischenlagen unterlegt, die den Keil in radialer Richtung verspannen. Die Biegespannung entspricht dann der Kraft, mit der die stabförmigen Leiter in den Nutengrund gepresst werden.

Weil die Querschnittsabmessungen der stabförmigen Leiter unvermeidbare Toleranzen aufweisen, muss jeder Keil individuell eingepasst werden, und es muss danach geprüft werden, ob jeder Keil die erforderliche Verspannung aufweist. Dazu wird bei den bisher gebräuchlichen Verfahren der Keil einfacherweise mit einem Hammer oder einem anderen metallischen Werkzeug abgeklopft und die Höhe des dadurch bewirkten Klangs mit dem Gehör beurteilt.

Die Nachteile dieses Verfahrens sind offensichtlich. Die Ausführung der beschriebenen Prüfung erfordert sehr viel Erfahrung, sie kann darum nur von einer entsprechend qualifizierten Person ausgeführt werden und ergibt trotzdem nur qualitative Werte, die ausserdem mit einer relativ hohen Fehlerquote behaftet sind. Weiter kann die Prüfung nur durchgeführt werden, bevor der Rotor in die Maschine eingebaut ist oder nachdem der Rotor ausgebaut wurde, da der Prüfer zu den Keilen Zugang haben muss.

Der vorliegenden Erfindung liegt darum die Aufgabe zugrunde, eine quantitative und reproduzierbare Messung der Verspannung der Keile der nutenteiligen Wicklung der Statoren von dynamoelektrischen Maschinen zu bieten.

Erfindungsgemäss wird diese Aufgabe mit einem Verfahren der eingangs genannten Art gelöst, das dadurch gekennzeichnet ist, dass zum Anschlagen jedes Keils ein Prüfkörper praktisch senkrecht auf den Keil geschleudert wird, die Aufprall sowie die Rückprallenergie gemessen werden und der Quotient aus Rückprall und Aufprallenergie als Mass für die Verspannung des Keils verwendet wird.

Aus der Zeitschrift Microtecnic, Nr. 2 (1979), Seiten 11-17, ist zur Härteprüfung metallischer Werkstoffe ein dynamisches Messverfahren bekannt, bei welchem ebenfalls ein Prüfkörper verwendet und auf das Werkstück geschleudert wird, dessen Härte gemessen werden soll; diese Härtemessung beruht ebenfalls auf der Messung von Aufprall und Rückprallenergie bzw. der Verwendung des daraus ermittelten Quotienten. Dabei muss das Werkstück aber entweder genügend gross oder aber fest eingespannt sein und das Ziel der Messung besteht in der Ermittlung des für das Werkstück charakteristischen Härtewertes.

Ferner ist es z. B. aus "Brockhaus der Naturwissenschaften und der Technik" (Wiesbaden 1971), Seiten 322-323, bekannt, bei der Härtemessung von Werkstoffen die sogenannte Fallhärte nach Shore durch Messung der Rücksprunghöhe eines kleinen Fallhammers zu ermitteln.

Die Verkeilungsprüfung ist jedoch ihrer Art nach keine Werkstoffprüfung, sondern die Ueberprüfung eines bestimmten Montage-, d. h. eines gewollten Verspannungszustandes, der üblicherweise durch Ueberprüfung der Fähigkeit zu akustischen Schwingungen festgestellt und letztlich als Elastizitätsmessung durchgeführt wird.

Die Verspannung kann praktisch unendlich viele Werte zwischen maximaler Schwingfähigkeit einerseits und völlig fehlender Schwingfähigkeit andererseits annehmen, wie beispielsweise der Ton einer mehr oder weniger gespannten Saite eines Streichinstruments, weshalb zwischen Härtemessung und Verspannungsmessung keine Analogie zu erkennen war, auch wenn es sich in beiden Fällen letzten Endes prinzipiell um eine Elastizitätsmessung handelt.

Das neue Verfahren zum Prüfen der Verkeilungsgüte kann ohne besondere Fachkenntnisse von einer Hilfsperson ausgeführt werden; es erlaubt eine objektive Messung der Verspannung der Keile und gibt quantifizierbare, reproduzierbare und mit einer sehr geringen Fehlerquote behaftete Messwerte. Schliesslich kann das neue Verfahren auch an Maschinen mit eingebautem Rotor ausgeführt werden, was für Wartung und periodische Zustandskontrollen von grossem Wert ist.

Bei einer bevorzugten Ausführungsform des neuen Verfahrens werden die Aufprall- und Rückprallenergie aus der Aufprall- bzw. Rückprallgeschwindigkeit des Prüfkörpers z. B. elektromagnetisch gemessen. Insbesondere kann man für die elektromagnetische Messung der Geschwindigkeit des Prüfkörpers eine Induktionsspule verwenden, deren Wicklungsachse praktisch in der Bahn des Prüfkörpers liegt, und die beim Durchlauf des Prüfkörpers in der Spule induzierte Spannung als Mass für die Geschwindigkeit auswerten.

Zum Dokumentieren der Messwerte können die Nuten und die darin eingesetzten Keile mit einer zum Identifizieren geeigneten Markierung versehen und die Quotienten in einer den Markierungen zuordenbaren Weise oder zusammen mit den zugeordneten Markierungen ausgedruckt oder gespeichert werden.

Nachfolgend wird ein Ausführungsbeispiel des neuen Verfahrens anhand der Figuren beschrieben. Es zeigen:

Fig. 1 den schematischen Teilschnitt durch den Stator einer dynamoelektrischen Maschine,

Fig. 2 den schematischen Schnitt durch eine zum Anschlagen der Keile vorgesehene Einrichtung,

Fig. 3 das vereinfachte Blockschaltbild eines zum Auswerten der elektromagnetischen Signale geeigneten Geräts, und

Fig. 4 die grafische Darstellung der Häufigkeit der Quotienten in Abhängigkeit von deren numerischem Wert bei einer nach dem neuen Verfahren durchgeführten Prüfung.

Die Grössenverhältnisse der in den Figuren gezeigten Teile entsprechen nicht der Wirklichkeit, sondern wurden mit Rücksicht auf eine einfache und klare Darstellung willkürlich gewählt.

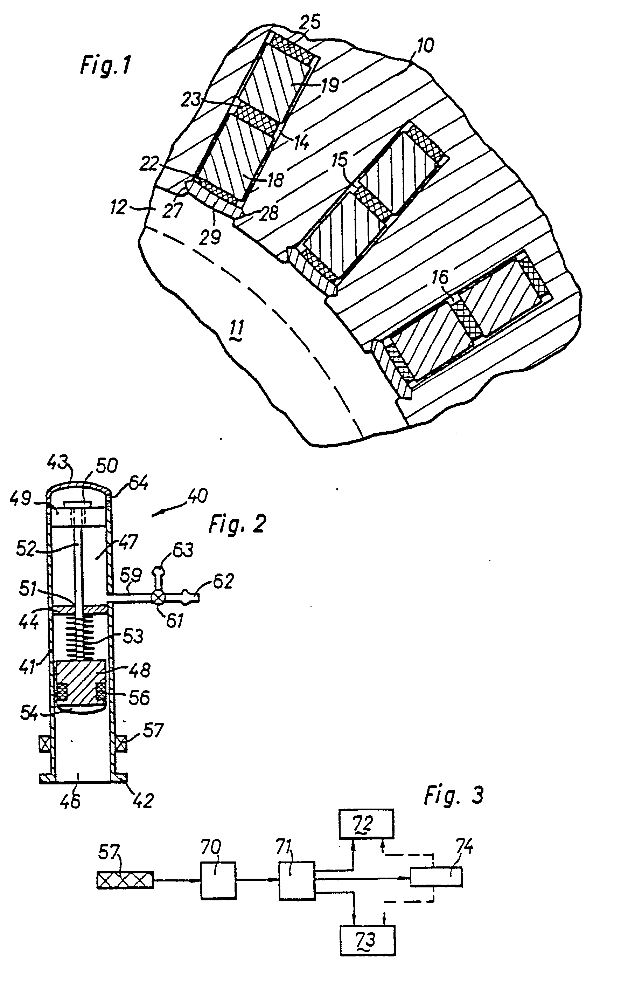

Die Fig. 1 zeigt schematisch einen Teil des Querschnitts durch eine dynamoelektrische Maschine und insbesondere einen Teil des Stators 10 sowie des Rotors 11 und des Gasspalts 12 zwischen Stator und Rotor. Der Stator enthält eine Vielzahl in axialer Richtung verlaufender Nuten 14, 15, 16. In jeder Nut sind zwei Wicklungselemente 18, 19 und einige z.B. aus Hartgewebe bestehende Zwischenlagen 22, 23, 25 eingelegt. Jede Nutwand enthält im äusseren Bereich eine in axialer Richtung verlaufende Vertiefung 27, 28, in die ein Keil 29 eingeschoben ist.

Die Fig. 2 zeigt den schematischen Schnitt durch eine Ausführungsform einer Vorrichtung 40 zum Ausführen des neuen Verfahrens. Die Vorrichtung enthält ein Führungsrohr 41, dessen in der Figur unteres Ende eine zum Anlegen an den Keil vorgesehene, flanschartige Verbreiterung 42 aufweist und dessen oberes Ende mit einer Kappe 43 verschlossen ist. Das Rohrinnere ist von einer Trennwand 44 in zwei Innenräume 46, 47 unterteilt. Der in der Figur untere Innenraum 46 dient als Führung für einen in axialer Richtung verschiebbaren Prüfkörper 48, der obere Raum 47 ist als Zylinder für einen Druckkolben 49 ausgebildet. Am Prüfkörper ist eine Zugstange 52 befestigt, die durch eine abgedichtete Oeffnung 51 in der Trennwand 44 und durch eine Bohrung im Druckkolben 49 geführt ist. Am freien Ende der Zugstange ist ein zum Aufsetzen auf den Druckkolben vorgesehener Teller 50 befestigt. Zwischen dem rückwärtigen Ende des Prüfkörpers und der Trennwand ist eine Druckfeder 53 eingelegt. Am vorderen Ende des Prüfkörpers ist ein gerundeter Hartmetallkopf 54 angeordnet. Der Prüfkörper weist eine umlaufende Nut auf, in die ein ringförmiger Permanentmagnet 56 eingesetzt ist. Auf der Aussenwand des unteren Innenraums 46 und im Bereich der flanschartigen Verbreiterung 42 ist eine Induktionsspule 57 befestigt. In der den oberen Innenraum 47 einschliessenden Wand des Führungsrohrs ist der Trennwand 44 benachbart eine Rohrleitung 59 befestigt. Am freien Ende dieser Rohrleitung ist ein Ventil 61 angeordnet, das den Innenraum 47 wahlweise mit einem Anschlussstutzen 62 für eine (nicht gezeigte) Druckluftleitung oder einer Auslassöffnung 63 verbindet. Das Ventil 61 ist vorzugsweise als Schiebeventil ausgebildet, das in der Ruhestellung den oberen Innenraum 47 mit dem Anschlussstutzen 62 verbindet und, wenn es gegen den Druck einer Feder verschoben wird, den Innenraum durch die Auslassöffnung 63 belüftet. In der Verschlusskappe 43 für den Innenraum 47 ist ein Lüftungsloch 64 vorgesehen.

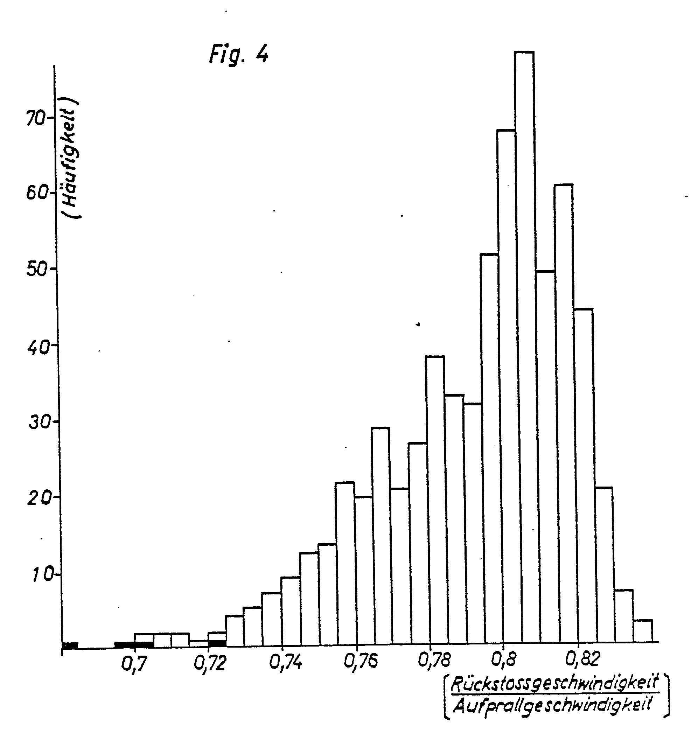

Die Fig. 3 zeigt das Blockschaltbild eines elektronischen Auswertegeräts für die mit der Vorrichtung gemäss der Fig. 2 ausgeführten Prüfungen. Dieses Gerät enthält eine Rechenschaltung 70, deren Eingang mit den Anschlussklemmen der Induktionsspule 57 der Vorrichtung 40 verbunden ist. Dieser Rechenschaltung ist eine Dekodiereinrichtung 71 nachgeschaltet, die mehrere Ausgänge aufweist, welche wahlweise mit einer Anzeigeeinrichtung 72 und/oder einem Druckwerk 73 und/ oder einem Speicher 74 verbunden werden können, Der Ausgang des Speichers kann wahlweise mit dem Druckwerk oder mit der Anzeigeeinrichtung verbunden werden.

Geeignete elektronische Schaltungen und Bauelemente sind jedem Fachmann bekannt und kommerziell erhältlich, weshalb hier auf eine detaillierte Beschreibung ausdrücklich verzichtet wird.

Beim Zusammenbau des Stators einer dynamoelektrischen Maschine werden die Wicklungsteile mit Zwischenlagen zuerst lose in die Nuten eingelegt. Danach werden die eingelegten Bauteile mit grosser Kraft zusammengepresst und eine Vielzahl relativ kurzer Keile nacheinander in die Vertiefungen der Nutenwände eingeschlagen. Dabei werden die Keile von dem in radialer Richtung wirkenden Gegendruck der Bauteile in der Richtung zur Maschinenachse ausgebogen, bis die Biegespannung der Keile und der Gegendruck im Gleichgewicht sind. Diese Technik ist jedem Fachmann bekannt, weshalb sie hier nicht weiter beschrieben wird.

Während des Verkeilens und nachdem die gesamte Statorwicklung verkeilt ist, wird die Güte der Verkeilung geprüft. Dabei wird davon ausgegangen dass der Rückstoss, den ein auf den Keil auftreffender Prüfkörper erleidet, um so grösser ist, je stärker der Keil ausgebogen bzw. verspannt ist, weshalb das Verhältnis der Rückstossgeschwindigkeit zur Aufprallgeschwindigkeit als Mass für die Verspannung verwendet wird.

Zur Ausführung des neuen Verfahrens wird die Vorrichtung gemäss der Fig. 2 am Anschlussstutzen 62 mit der nichtgezeigten Druckluftleitung, und die Anschlussklemmen der Induktionsspule 57 werden mit dem Eingang der Rechenschaltung verbunden. Die Vorrichtung wird dann mit der flanschartigen Verbreiterung 42 an einen Keil angelegt. Weil das Ventil 61 im Ruhezustand den Anschlussstutzen 62 mit dem oberen Innenraum 47 verbindet, steht dieser Innenraum unter dem Druck der eingeleiteten Druckluft, die den Kolben 49 in die gezeigte obere Stellung verschiebt. Dabei wird auch der mit dem Kolben verbundene Prüfkörper 48 gegen den Druck der Feder 53 in die gezeigte obere Stellung geschoben. Sobald das Ventil 61 gegen den Druck einer Stellfeder in seine Arbeitsstellung verschoben und der Innenraum 47 mit der Auslassöffnung 63 verbunden wird, wird der Ueberdruck Innenraum 47 abgebaut, und die Feder 53 schleudert den Prüfkörper zum unteren Ende des Führungsrohrs 41. Dabei wird auch der Permanentmagnet 56 durch die Induktionsspule 57 geführt und erzeugt an deren Anschlussklemmen einen Spannungsstoss. Der mit seinem Hartmetallkopf 54 auf den Keil auftreffende Prüfkörper wird vom Keil zurückgestossen, wobei der Permanentmagnet erneut durch die Induktionsspule geführt wird und einen weiteren Spannungsstoss erzeugt. Dabei wird wegen der verschiebbaren Anordnung der Zugstange 52 am Druckkolben 49 der Rückstoss des Prüfkörpers von der Reibung zwischen dem Kolben und der Zylinderwand nicht beeinträchtigt.

Die Spannungsspitzen der beiden Spannungsstösse sind der geschwindigkeit, mit der der Permanentmagnet durch die Induktionsspule geführt wurde, proportional. Weiter darf angenommen werden, dass die Beschleunigung des Prüfkörpers durch die sich entspannende Feder 53 und damit auch die Aufprallgeschwindigkeit praktisch immer gleich gross sind, während die Rückstosskraft und damit auch die Geschwindigkeit während des Rückstosses der Verspannung des Keiles proportional sind. Dann gibt das Verhältnis oder der Quotient der vorzeichenunabhängigen Werte für die dem Rückstoss entsprechende Spannungsspitze zu der dem Aufprall entsprechenden Spannungsspitze ein Mass für die Keilspannung.

Die beim Aufprall und beim Rückstoss des Prüfkörpers induzierten Spannungsstösse werden an den Eingang der Rechenschaltung 70 geleitet. Die Rechenschaltung speichert den zuerst eingehenden Spannungsstoss. Erscheint dann innert einer vorgegebenen Zeitspanne ein zweiter Spannungsstoss mit entgegengesetztem Vorzeichen am Eingang der Rechenschaltung, dann bildet diese ein Ausgangssignal, das dem Quotienten aus dem nachfolgenden zu dem vorgängigen Spannungsstoss entspricht. Dieses Ausgangssignal wird an die Dekodiereinrichtung 71 geleitet, an deren Ausgängen dann Signalfolgen erscheinen, die zum Ansteuern der optischen Anzeigeeinrichtung 72 oder des Druckwerks 73 oder zum Einspeichern in den Speicher 74 geeignet sind.

Das neue Verfahren und die beschriebene Vorrichtung zur Prüfung der Verkeilung der Statorwicklung wurden an mehreren Hydro- und Turbogeneratoren mit Leistungen von bis zu 1300 MVA erprobt. Ein typischer Stator hatte einen Durchmesser von 1,5 m, und im inneren Umfang dieses Stators waren 90 Nuten angeordnet. In jede Nut waren 25 Keile aus glasfaserverstärktem Kunststoff eingesetzt, von denen jeder eine Länge von 30 cm, eine Breite von 4 cm und eine Dicke von 1 cm aufwies. Der von den in die Nut eingelegten Teilen auf die Keile wirkende Druck lag im Bereich um 100 N/cm$^2$, was eine Durchbiegung der Keile von etwa 20 µm bewirkte. Der Durchmesser des Prüfkörpers betrug etwa 5 mm, die Federkraft der Spannfeder etwa 10 N.mm und die Auftreffgeschwindigkeit des Prüfkörpers auf den Keil etwa 30 m/sec.

Für eine zuverlässige Prüfung der Güte der Verkeilung wird die Verspannung jedes Keils mehrfach, und zwar in Abständen von beispielsweise 5 cm geprüft und der jeder Einzelprüfung zugehörige Quotient auf einem Papierstreifen ausgedruckt. Für eine einfache Zuordnung der Zahlenwerte auf dem Papierstreifen zu den entsprechenden Keilen kann die Prüfvorrichtung mit einer zusätzlichen elektrischen Drucktaste ausgerüstet sein, die vor Beginn der Prüfung eines Keils betätigt wird und auf dem Prüfstreifen eine Markierung erzeugt. Nach dem Prüfen der Keile einer Nut kann die Drucktaste zweimal betätigt werden, um eine doppelte Markierung auf dem Papierstreifen zu erzeugen. Auf diese Weise ist es möglich, nach dem Messen aller Keile der Statorwicklung diejenigen Keile zu bestimmen, deren Verspannung dem angestrebten Wert nicht entspricht.

In Fig. 4 ist die Häufigkeit der Quotienten der Messwerte in Abhängigkeit vom numerischen Wert der Quotienten für eine Messreihe mit 648 Einzelmessungen aufgetragen. Die gleiche Messreihe wurde nach bisher gebräuchlichen Verfahren durch Abklopfen mit einem Hammer und subjektives Bewerten des dadurch erzeugten Klangs wiederholt. Die dabei aufgefundenen Messorte mit ungenügend bewerteter Verkeilung sind in der Figur schwarz eingezeichnet. Die Figur zeigt deutlich, dass die nach den bisherigen subjektiven Verfahren als fehlerhaft befundenen Verkeilungen im Bereich der kleinsten gemessenen Quotienten, d.h. aber auch der kleinsten Verspannung liegen, womit die Annahmen, von denen das neue Verfahren ausgeht, bestätigt werden. Die Figur zeigt weiter, dass mit den bisherigen subjektiven Verfahren nicht alle Keile aufgefunden wurden, deren quantitativ bestimmte Verspannung in diesem als unzureichend klassierten Bereich liegen, was den mit dem neuen Verfahren erreichbaren Fortschritt bestätigt.

Es versteht sich, dass das neue Verfahren und die beschriebene Vorrichtung auf vielerlei Arten abgewandelt und an spezielle prüfbedingungen angepasst werden können. Beispielsweise kann die in Fig. 2 gezeigte Vorrichtung an einem Fahrgestell oder einem Schlitten befestigt werden, das oder der an den seitlichen Kanten der Nuten oder auf den aneinanderliegenden Keilen abrollt bzw. verschiebbar ist, so dass auch bei Maschinen mit grosser axialer Länge die Messung von ausserhalb des Stators ausgeführt werden kann. Weiter kann die Vorrichtung so weit verkürzt werden, dass sie auf dem beschriebenen Fahrgestell oder dem Schlitten in den bis zu 8 cm breiten Spalt zwischen dem Stator und dem Rotor einer fertigmontierten Maschine eingefahren bzw. eingeschoben werden kann, was die Prüfung der Verkeilung ermöglicht, ohne dass deswegen der Rotor ausgebaut werden muss. Es versteht·sich auch, dass zur Vereinfachung der Auswertung der ausgedruckten Zahlenwerte die Dekodierschaltung 71 so eingestellt werden kann, dass Zahlenwerte, die über einem vorgegebenen Wert liegen, und solche, die unter diesem Wert liegen mit unterschiedlichen Farben ausgedruckt werden. Die einzelnen Prüfungen können gesamthaft oder stichprobenweise sowohl im Verlaufe der Herstellung einer Maschine, aber auch anlässlich einer Revision wiederholt und mit früher ausgedruckten oder gespeicherten Werten verglichen werden, was ermöglicht, die Langdauerstabilität oder -instabilität der Verkeilung zu überwachen. Schliesslich ist es auch möglich, anstelle der beschriebenen pneumatischen Einrichtung zum Spannen der Feder, die den Prüfkörper auf den Keil schleudert, eine manuell betätigte Spanneinrichtung bzw. einen Elektromagneten zu verwenden oder den Prüfkörper direkt mit Hilfe eines Elektromagneten auf den Keil zu schleudern.

## Patentansprüche

1. Verfahren zum Prüfen der Güte der Verkeilung der nutenteiligen Wicklung des Stators einer dynamoelektrischen Maschine durch Anschlagen jedes Keils (29) und Erfassung und Bewertung der hierdurch hervorgerufenen Reaktion zur Prüfung der mechanischen Verspannung aller Keile in den Nuten, dadurch gekennzeichnet, dass zum Anschlagen jedes Keils (29) ein Prüfkörper (48) praktisch senkrecht auf den Keil (29) geschleudert wird, die Aufprall sowie die Rückprallenergie gemessen werden und der Quotient aus Rückprall und Aufprallenergie als Mass für die Verspannung des Keils (29) verwendet wird.

2. Verfahren nach Anspruch 1, dadurch gekennzeichnet, dass die Aufprall- sowie die Rückprallenergie aus der Aufprall- bzw. Rückprallgeschwindigkeit des Prüfkörpers (48) bestimmt werden.

3. Verfahren nach Anspruch 2, dadurch gekennzeichnet, dass die Aufprall- und die Rückprallgeschwindigkeit des Prüfkörpers (48) elektromagnetisch gemessen werden.

4. Verfahren nach Anspruch 3, dadurch gekennzeichnet, dass für die elektromagnetische Messung der Geschwindigkeit des Prüfkörpers (48) eine Induktionsspule (57) verwendet wird, deren Wicklungsachse praktisch in der Bahn des Prüfkörpers (48) liegt und die beim Durchlauf des Prüfkörpers in dieser Spule (57) induzierte Spannung als Mass für die Geschwindigkeit gewertet wird.

5. Verfahren nach Anspruch 1, dadurch gekennzeichnet, dass der Prüfkörper (48) mittels einer vorgängig gespannten Feder (53) auf den Keil (29) geschleudert wird.

6. Verfahren nach Anspruch 1, dadurch gekennzeichnet, dass zum Dokumentieren der Messwerte die Nuten (14, 15, 16) und die darin eingesetzten Keile (29) mit einer zum Identifizieren geeigneten Markierung versehen und die Quotienten in einer den Markierungen zuordnbaren Weise oder zusammen mit der zugeordneten Markierung ausgedruckt oder gespeichert werden.

## Revendications

1. Procédé pour tester la qualité du calage de l'enroulement réparti dans les rainures du stator d'une machine dynamoélectrique, par percussion de chaque cale (29) et par détection et évaluation de la réaction ainsi provoquée pour tester la mise sous contrainte mécanique de toutes les cales dans les rainures, caractérisé en ce que, en vue de la percussion de chaque cale (29), une masse percutante (48) est projetée pratiquement verticalement sur la cale (29), l'énergie d'impact et l'énergie de rebondissement sont mesurées et le quotient de l'énergie de rebondissement et de l'énergie d'impact est utilisé comme mesure pour la mise sous contrainte de la cale (29).

2. Procédé suivant la revendication 1, caractérisé en ce que l'énergie d'impact et l'énergie de rebondissement sont déterminées à partir de la vitesse d'impact et de la vitesse de rebondissement de la masse percutante (48).

3. Procédé suivant la revendication 2, caractérisé en ce que la vitesse d'impact et la vitesse de rebondissement de la masse percutante (48) sont mesurées électromagnétiquement.

4. Procédé suivant la revendication 3, caractérisé en ce que pour la mesure électromagnétique de la vitesse de la masse percutante (48), on utilise une bobine d'induction (57) dont l'axe d'enroulement est pratiquement aligné sur le trajet de la masse percutante (48) et on exploite la tension induite dans la bobine (57) lors du déplacement de la masse percutante comme mesure de la vitesse.

5. Procédé suivant la revendication 1, caractérisé en ce que la masse percutante (48) est projetée sur la cale (29) au moyen d'un ressort (53) préalablement comprimé.

6. Procédé suivant la revendication 1, caractérisé en ce que pour établir une documention concernant les valeurs de mesure, les rainures (14, 15, 16) et les cales (29) qui y sont insérées sont pourvues d'une marque adéquate d'identification et les quotients sont imprimés ou stockés d'une manière permettant de les associer aux marques ou avec les marques correspondantes.

## Claims

1. Method of testing the quality of the wedging of the slot winding of the stator of a dynamo-electric machine by striking each wedge (29) and recording and evaluating the reaction caused by this for testing the mechanical strain in all the wedges in the slots, characterized in that, to strike each wedge (29), a test body (48) is thrown virtually perpendicularly on to the wedge (29), the impact and also the rebound energy are measured and the quotient of rebound and impact energy is used as a measure of the strain in the wedge (29).

2. Method according to claim 1, characterised in that the impact and also the rebound energy are determined from the impact and rebound velocity respectively of the test body (48).

3. Method according to claim 2, characterized in that the impact and rebound velocity of the test body (48) are measured electro-magnetically.

4. Method according to claim 3, characterized in that an induction coil (57) is used for the electromagnetic measurement of the velocity of the test body (48), the winding axis of which induction coil (57) lies virtually in the path of the test body (48), and the voltage induced in this coil (57) when the test body passes through is evaluated as a measure of the velocity.

5. Method according to claim 1, characterized in that the the test body (48) is thrown onto the wedge (29) by means of a preloaded spring (53).

6. Method according to claim 1, characterized in that to document the measured values, the slots (14,15,16) and the wedges (29) inserted therein are provided with a mark suitable for identification, and the quotients are printed out or stored in a manner which can be allocated to the marks or together with the allocated marks.

Fig. 1

Fig. 2

Fig. 3

Fig. 4